Europäisches Patentamt

(19) European Patent Office

Office européen des brevets

(11) Publication number: **0 262 493 B1**

# EUROPEAN PATENT SPECIFICATION

(45) Date of publication of patent specification: **19.11.92**  (51) Int. Cl.⁵: **H01L 23/58**, H01L 23/48

(21) Application number: **87113320.3**

(22) Date of filing: **11.09.87**

(54) **Electronic package with distributed decoupling capacitors.**

(30) Priority: **30.09.86 US 913435**

(43) Date of publication of application:
**06.04.88 Bulletin 88/14**

(45) Publication of the grant of the patent:
**19.11.92 Bulletin 92/47**

(84) Designated Contracting States:
**DE FR GB IT**

(56) References cited:
**EP-A- 0 083 020**
**EP-A- 0 083 405**
**EP-A- 0 180 219**
**US-A- 4 231 154**
**US-A- 4 420 652**

**PATENT ABSTRACTS OF JAPAN, vol. 10, no.**
**293 (E-443)[2349], 4th October 1986; & JP-**
**A-61 112 369**

**IDEM**

**PATENT ABSTRACTS OF JAPAN, vol. 8, no.**
**194 (E-264)[1631], 6th September 1984; & JP-**
**A-59 82 753 12-05-1984**

**IDEM**

**PATENT ABSTRACTS OF JAPAN, vol. 10, no.**
**145 (E-407)[2202], 28th May 1986; & JP-A-61**
**6846**

(73) Proprietor: **International Business Machines**
**Corporation**
**Old Orchard Road**
**Armonk, N.Y. 10504(US)**

(72) Inventor: **Brown, Michael B.**
**4 Alpine Road**
**Binghamton New York 13903(US)**
Inventor: **Ebert, William S.**
**RD No. 1, Tilbury Hill Road**
**Endicott, NY 13760(US)**
Inventor: **Olson, Leonard T.**
**2628 Laguna Drive**
**Endwell, NY 13760(US)**
Inventor: **Sloma, Richard R.**
**304 Hill Avenue**
**Endicott, NY 13760(US)**

(74) Representative: **Klocke, Peter, Dipl.-Ing.**
**IBM Deutschland GmbH Patentwesen und**
**Urheberrecht Schönaicher Strasse 220**
**W-7030 Böblingen(DE)**

## Description

Background of the Invention

1. Field of the invention

This invention relates to integrated circuit semiconductor chip packages and more particularly to semiconductor chip carrier, first level electronic packages having distributed high frequency decoupling capacitors as a part of the package.

2. Background Information

As very large scale integrated (LSI) circuits tend to get more complex, there is a need to switch more output driver circuits at a faster rate in order to increase the performance thereof. This increase in the switching rate results in an increase in the amount of electrical noise which is associated therewith. Various techniques have been utilized in the art to minimize the level of noise associated with the increase in the magnitude of the switching rate. One known technique for reducing the level of noise is to incorporate discrete capacitors as a decoupling capacitor between associated voltage pins. Generally, the discrete capacitor, which is mounted a distance away from the semiconductor chip, is electrically coupled thereto by a plurality of power wiring lines or large power buses. These power wiring lines typically represent long inductance paths. Moreover, as the switching rate of the current flowing in the plurality of wiring lines increases, a voltage drop develops thereacross. The voltage drop is viewed as unwanted power distribution noise. One technique of minimizing the inductance paths is to move the discrete capacitor as close to the semiconductor chip as possible. However, in view of either the layout of the wiring lines associated with the semiconductor chip or the physical dimensions of the discrete capacitor, the discrete capacitor can not be positioned such that there is no voltage drop or noise. Additionally, the discrete capacitors used for this purpose are usually high frequency, low inductance capacitors which increase the cost associated with the use of this technique. The level of noise created by the increase in the rate at which the current switches limits the performance and the number of LSI circuits which can be switched simultaneously.

Consequently, there is a need for a technique for reducing the noise associated with the increase in the rate at which the current switches while minimizing the inductance paths and the cost associated therewith.

US-A-4 420 652 discloses a shell of a hermetically sealed package which has a through hole and a circuit board is inserted and fixed hermetically into the through hole, and a can is fixed hermetically to the shell. The circuit board consists of a sealed part which is sealed hermetically by the hermetically sealed package, a fixed part to which the shell is fixed, and a projecting part which projects out from the hermetically sealed package. As the circuit pattern into which decoupling capacitors are integrated extends from the sealed part through the fixed part to the projecting part, it is not necessary to use terminal pins and instead a large number of external lead electrodes are taken out from the hermetically sealed package.

An integrated-circuit chip or the like which is sealed by the hermetically sealed package can be shielded from electromagnetic influence by the metallic shell and the metallic can.

EP-A-0 180 219 describes a capacitor built-in integrated circuit packaged unit and process of fabrication thereof. This unit comprises an electrically conductive support member, first and second lead elements associated with the conductive support member, a stack of a plurality of layers comprising a first insulating layer of a highly dielectric material formed on the conductive support member, an electrically conductive layer on the first insulating layer, and a second insulating layer on the conductive layer, the conductive layer having a portion exposed by the second insulating layer, a semiconductor integrated circuit chip having first and second electrodes which are electrically isolated from each other, the second insulating layer intervening between the conductive layer and the semiconductor integrated circuit chip, a bonding wire electrically connecting the first electrode to the first lead element, and a bonding wire electrically connecting the second electrode to the exposed portion of the conductive layer and to the second lead element. The dielectric material forming the first insulating layer provides a capacitor between the first and second electrodes on the semiconductor integrated circuit chip.

In US-A-A 231 154 an electronic package assembly method is disclosed for making a single conductive layer package. The package comprises an insulator pin carrier, a thin, flexible printed circuit polyimide member having printed circuit conductors bonded to the heads of the pins of the carrier, and one or more integrated circuit chips with a high density input/output I/O terminal array on the bottom surface of each chip bonded to a corresponding registerable array of printed circuit conductor pads of the polyimide member. The method provides a reliable manner for fabrication of the package assembly which minimizes the risk of destroying the flexibility of the printed circuit member and/or its integrity during the making of the assembly and/or the subsequent thermal cycling associated with the assembly.

This disclosure is concerned with high density packaging on a thin film flexible chip carrier. This direct attachment goes to circuit lines and not to capacitor plates and therefore does not disclose facts concerning noise reduction.

## Objects of the Invention

Therefore it is an object of the invention to provide an improved electronic package for semiconductor chips.

It is another object of the invention to provide decoupling capacitors which are an integral part of a power distribution system.

It is a further object of the invention to provide a technique for forming a plurality of decoupling capacitors simultaneously with the formation of the power distribution system.

It is still an object of the invention to provide a technique of increasing the capacitance of a decoupling capacitor by using a plurality of interleaved layers of metal and dielectric material.

## Summary of the Invention

In accordance with these objects, the features and advantages of the invention are accomplished by an electronic packaging structure according to claim 1. This invention, as claimed, contemplates an electronic package which includes decoupling capacitors. A lower layer of metal, formed on a substrate includes at least one portion which forms a first plate of a decoupling capacitor and includes at least one pad for attachment of a semiconductor chip. A thin layer of dielectric material is positioned on and covers the lower layer of metal. A upper layer of metallurgy is formed on the layer of dielectric material and includes at least one pad for attachment to a contact of the semiconductor chip. The pad is positioned relative to the first plate of the decoupling capacitor to form a second plate thereof having the thin layer of dielectric material therebetween.

## Brief Description of the Drawings

This invention will be described in greater detail by referring to the accompanying drawings and the description of the best mode that follows.

FIG. 1 is an exploded isometric view of an electronic package in accordance with the principles of this invention.

FIG. 2 is a sectional view of the electronic package taken along line 2-2 in FIG. 1.

FIG. 3 is a sectional view of the electronic package of FIG. 1 illustrating the use of discrete capacitors.

## Description of the Best Mode for Carrying Out the Invention

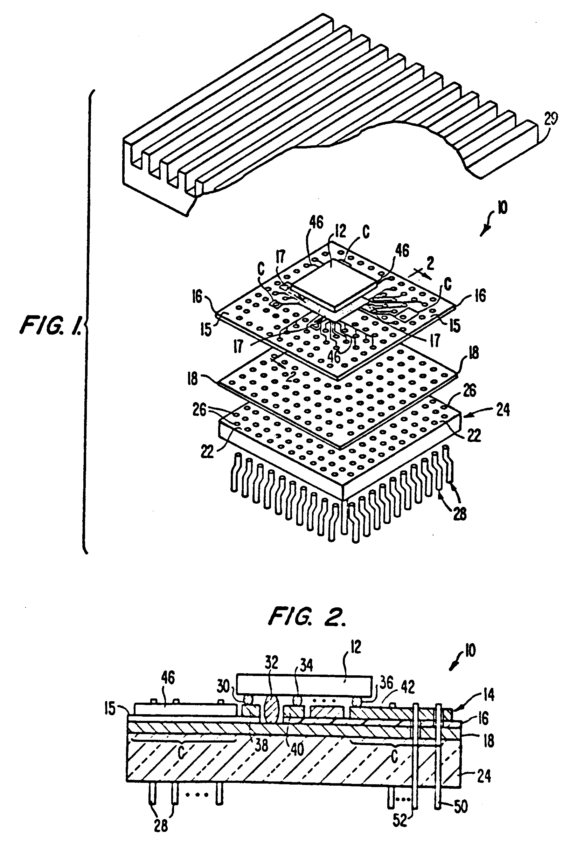

FIG. 1 illustrates an isometric and exploded view of an electronic package or a carrier 10 for large scale integrated (LSI) electronic circuit chips such as a chip 12. The chip 12 is electrically coupled to a first upper layer of metal 14 (FIG. 2) formed on an upper surface 15 of a dielectric layer 16. The dielectric layer 16 consists of a thin film of dielectric material such as polyimide. The first layer of metal 14, which provides electrical connections for both signals and power for the chip 12, also serves as one of the plates of a capacitor. This one plate of the capacitor C includes at least one pad in pad area 17 to which the chips may be mounted. A second (lower) layer of metal 18 is positioned adjacent to a lower surface of the dielectric layer 16 which electrically isolates the second layer of metal from the first layer of metal 14. The second layer of metal 18 is coupled to a first potential, such as ground potential, and serves as a ground plane for the carrier 10. The second layer of metal 18 extends beneath the first plate including the pad 17 of the first layer of metal 14 and serves as another plate of the capacitor. Moreover, the second layer of metal 18 is supported on an upper surface 22 of a substrate 24. A plurality of holes 26 are formed in the substrate 24 for receiving a plurality of pins 28 therein. The pins 28, which extend through the substrate 24, the second layer of metal 18, the dielectric layer 16 and the first layer of metal 14 facilitate the coupling of signals and power to the chip 12. Additionally, selected ones of the pins 28 couple the first potential to the second layer of metal 18. A cap 29 (shown enlarged) is positioned over and encloses all or a portion of the carrier 10.

Referring to FIG. 2, there is shown a sectional view of the carrier 10 in its assembled form. As noted above, the chip 12 is supported on the upper surface 15 of the dielectric layer 16. A plurality of solder joints 30, 32, 34 and 36, which are representative of perhaps dozens of such solder joints, provide support for and electrical connections for both signals and power to the chip 12. Solder joints 30, 32, 34 and 36 facilitate the electrical connections between the chip 12 and mounting pads 38, 40 and 42 of the first layer of metal 14 and a ground potential plane of the second layer of metal 18. The mounting pads 38, 40 and 42 are an integral part of the first layer of metal 14 and are formed simultaneously therewith. The first layer of metal 14 further includes a plurality of wiring lines 46, which facilitate the interconnection of selected ones of the pins 28 to selected ones of the solder joints.

As further noted above, the second layer of metal 18 is coupled to the first potential and serves as one plate of at least one capacitor. As one of the plates of the capacitor, the second layer of metal extends from the solder joint 32 out to a module ground pin such as pin 50. In a similar manner, the first level of metal 14, as the other plate of the capacitor, extends from a power solder joint, such as solder joint 36, and out to a module voltage pin 52 coupled to a second potential. It should be noted that the size of the first and the second plates is limited only by the space available to form the plates. Thus, the first and the second plates may extend beyond the module ground pin 50 and the module voltage pin 52, respectively. In this manner, a decoupling parallel-plate capacitor C is formed having the dielectric layer 16 positioned between the first layer of metal 14 and the second layer of metal 18. Moreover, the capacitor C is formed at the mounting pad 42 of the chip 12 and is distributed to and beyond the module voltage pin 52.

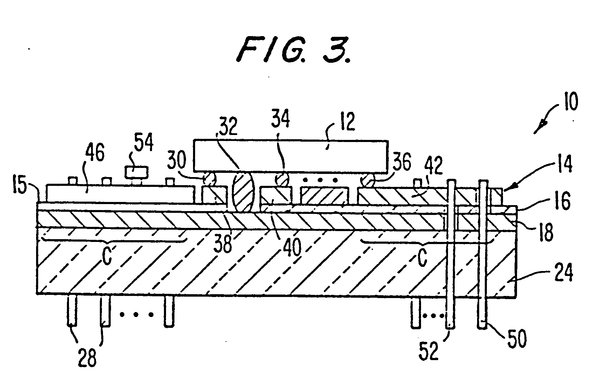

The capacitance of the decoupling parallel-plate capacitor C may be increased by substituting a dielectric material having a higher dielectric constant than that of the polyimide material. Another technique for increasing the capacitance of the decoupling capacitor C is to increase the size of the first and the second plates thereof. Moreover, the capacitance of the capacitor C may be increased by adding additional alternating layers of metal and dielectric material using techniques which are well known in the art. Alternately, if space on the substrate is limited, the capacitance of the capacitor C may be increased by coupling a discrete capacitor 54, which is well known in the art, to the parallel-plate capacitor as shown in FIG. 3.

Referring to FIG. 3, the parallel-plate capacitor C is formed in the manner as set forth above. The discrete capacitor 54 is then mounted on an upper surface of the first layer of metal 14 and electrically coupled to the first layer of metal and the second layer of metal 18 using techniques which are well known in the art.

In summary, the capacitor C is formed simultaneous with application of the first layer of metal 14, the dielectric layer 16 and the second layer of metal 18 to the substrate 24. The ground plane or the second layer of metal 18 which includes a first layer of chrome, a middle layer of copper and a second layer of chrome, is formed on the substrate 24. The substrate 24 can be a ceramic substrate or any thin film structure such as that used in tape automated bonding. Alternately, the substrate 24 can be a structure such as a circuit board having an epoxy base. Thereafter, metal is etched away to form the personality of the substrate 24, which includes at least one pad to serve as the first plate of the decoupling capacitor C. The thin film dielectric layer 16 is then applied to the second layer of metal 18 using techniques such as sputtering which are well known in the art. Openings are formed in the dielectric layer 16 to facilitate connections between the solder joint 32 and the second layer of metal 18. The first layer of metal 14, which is formed on the upper surface 15 of dielectric layer 16, includes a first layer of chrome, a middle layer of copper and a second layer of chrome. The first layer of metal 14 further includes portions, such as pads 38, 40 and 42, positioned relative to the second layer of metal 18 to form the capacitor C therebetween. The capacitor C, in the form of a parallel-plate capacitor, extends from the selected one of the pads 38, 40 and 42, serving as the second plate of the capacitor, out and beyond a selected one of the voltage pins, such as pin 52. Thus, when signals in the form of current begin to flow, they encounter the capacitor C and the capacitor is present along the entire path of current flow between the voltage pin 52 and the pad 42. Moreover, the shape of first and second plates of the capacitor C is not important. The capacitor C can be formed on any available space between the pins 28 as long as the first layer of metal 14 is positioned relative to the second layer of metal 18 having the dielectric layer 16 positioned therebetween and the total area of the first and the second plates is such as to increase the capacitance of the capacitor C to the desired level. Thus, the capacitor C may be formed on the space around and beneath the chip 12.

## Claims

1. An electronic packaging structure comprising:
   (a) a substrate (24);
   (b) a layer of metallurgy (18) on the substrate, said layer of metallurgy having a pad for electrical attachment thereto and including at least one portion forming a first plate of a capacitor (C, C');
   (c) a dielectric layer (16) covering the layer of metallurgy;
   (d) a layer of metallurgy (14) disposed on the dielectric layer, forming a second plate of said capacitor and having at least one pad (38, 40, 42) for electrical attachment thereto, said second plate being positioned relative to the first plate of the capacitor and separated therefrom by a portion of the dielectric layer;
   (e) a plurality of holes (26) extending from the bottom of said substrate through said substrate, said layers of metallurgy and the dielectric layer to the top of said layer of metallurgy disposed on the dielectric layer;

(f) a semiconductor chip (12) mounted on the layer of metallurgy disposed on the dielectric layer, the semiconductor chip being electrically connected to the pads of both of said layers of metallurgy by a plurality of solder joints (30, 32, 34, 36); and

(g) a plurality of pins (28) extending entirely through said holes and being coupled to said layers of metallurgy, thereby providing electrical interconnections to said semiconductor chip from the bottom of said substrate.

2. The packaging structure as recited in claim 1 wherein the layer of metallurgy disposed on the substrate includes:

(a) a first layer of chrome formed on the substrate;

(b) a layer of copper formed over and covering the first layer of chrome; and

(c) a second layer of chrome formed over and covering the layer of copper.

3. The packaging structure as recited in claim 2 wherein the layer of metallurgy disposed on the dielectric layer includes:

(a) a first layer of chrome formed on the dielectric layer;

(b) a layer of copper formed over and covering the first layer of chrome; and

(c) a second layer of chrome formed over and covering the layer of copper.

**Patentansprüche**

1. Elektronische Packungsstruktur, folgendes umfassend:

(a) ein Substrat (24);

(b) eine metallurgische Schicht (18) auf dem Substrat, wobei besagte metallurgische Schicht mit einer Kontaktfläche zum elektrischen Anschluß daran versehen ist und mindestens ein Teil umfaßt, welches eine erste Platte eines Kondensators (C, C') bildet;

(c) eine die metallurgische Schicht bedeckende dielektrische Schicht (16);

(d) eine auf der dielektrischen Schicht angeordnete metallurgische Schicht (14), die eine zweite Platte besagten Kondensators bildet und mindestens eine Kontaktfläche (38, 40, 42) zum elektrischen Anschluß daran aufweist, wobei besagte zweite Platte zur ersten Platte des Kondensators hin angeordnet und davon durch einen Teil der dielektrischen Schicht getrennt ist;

(e) eine Vielzahl von Löchern (26), die sich von der Unterkante des Substrats durch dasselbe, die metallurgischen Schichten und die dielektrische Schicht zur Oberkante besagter metallurgischer Schicht auf der dielektrischen Schicht erstrecken;

(f) ein Halbleiterchip (12), welches auf der über der dielektrischen Schicht befindlichen metallurgischen Schicht angeordnet ist, wobei das Halbleiterchip mit den Kontaktflächen beider metallurgischer Schichten durch eine Vielzahl von Lötverbindungen (30, 32, 34, 36) verbunden ist, sowie

(g) eine Vielzahl von Stiften (28), die sich völlig durch besagte Löcher erstrecken und mit besagten metallurgischen Schichten gekoppelt sind, wodurch elektrische Verbindungen zum Halbleiterchip von der Unterkante des Substrats hergestellt werden.

2. Packungsstruktur nach Anspruch 1, bei der die auf dem Substrat angeordnete metallurgische Schicht folgendes umfaßt:

(a) eine erste auf dem Substrat ausgebildete Chromschicht;

(b) eine über der ersten Chromschicht gebildete und dieselbe bedeckende Kupferschicht sowie

(c) eine über der Kupferschicht gebildete und dieselbe bedeckende zweite Chromschicht.

3. Packungsstruktur nach Anspruch 2, bei der die auf der dielektrischen Schicht angeordnete metallurgische Schicht folgendes umfaßt:

(a) eine auf der dielektrischen Schicht gebildete erste Chromschicht;

(b) eine auf der ersten Chromschicht gebildete und dieselbe bedeckende Kupferschicht sowie

(c) eine auf der Kupferschicht gebildete und dieselbe bedeckende zweite Chromschicht.

**Revendications**

1. Structure d'empaquetage électronique comprenant :

(a) un substrat (24) ;

(b) une couche de métal (18) sur le substrat, ladite couche de métal ayant un plot pour liaison électrique à celui-ci et comportant au moins une partie formant une première plaque d'un condensateur (C, C') ;

(c) une couche diélectrique (16) recouvrant la couche de métal ;

(d) une couche de métal (14) disposée sur la couche diélectrique, formant une seconde plaque dudit condensateur et ayant au moins un plot (38, 40, 42) pour liaison électrique à celle-ci, la seconde plaque étant positionnée par rapport à la première plaque du condensateur et séparée de celle-ci par une partie de la couche diélectrique ;

(e) une pluralité de trous (26) s'étendant du fond dudit substrat à travers ledit substrat, lesdites couches de métal et la couche diélectrique au sommet de ladite couche de métal disposée sur la couche diélectrique ;

(f) une puce semi-conductrice (12) montée sur la couche de métal disposée sur la couche diélectrique, la puce semi-conductrice étant reliée électriquement aux plots desdites couches de métal par une pluralité de joints par soudure (30, 32, 34, 36), et

(g) une pluralité de broches (28) passant entièrement à travers lesdits trous et étant couplées auxdites couches de métal, procurant de ce fait des interconnexions électriques à ladite puce semiconductrice à partir du fond dudit substrat.

2. Structure d'empaquetage selon la revendication 1, dans laquelle la couche de métal disposée sur le substrat comporte :

(a) une première couche de chrome formée sur le substrat ;

(b) une couche de cuivre formée sur et recouvrant la première couche de chrome, et

(c) une seconde couche de chrome formée sur et recouvrant la couche de cuivre.

3. Structure d'empaquetage selon la revendication 2, dans laquelle la couche de métal disposée sur la couche diélectrique comprend :

(a) une première couche de chrome formée sur la couche diélectrique ;

(b) une couche de cuivre formée sur et recouvrant la première couche de chrome, et

(c) une seconde couche de chrome formée sur et recouvrant la couche de cuivre.

FIG. 1.

FIG. 2.

# FIG. 3.